(19) Europäisches Patentamt
European Patent Office
Office européen des brevets

(11) **EP 3 396 016 B1**

(12) **EUROPEAN PATENT SPECIFICATION**

(45) Date of publication and mention
of the grant of the patent:
**13.05.2026 Bulletin 2026/20**

(21) Application number: **16878357.9**

(22) Date of filing: **07.12.2016**

(51) International Patent Classification (IPC):
*C23C 14/00* (2006.01)   *C23C 14/34* (2006.01)
*C23C 14/50* (2006.01)   *C23C 14/54* (2006.01)

(52) Cooperative Patent Classification (CPC):
**C23C 14/505; C23C 14/0078; C23C 14/3464;
C23C 14/542**

(86) International application number:
**PCT/JP2016/086307**

(87) International publication number:
**WO 2017/110464 (29.06.2017 Gazette 2017/26)**

(54) **FILM FORMATION APPARATUS AND FILM FORMATION METHOD**

FILMBILDUNGSVORRICHTUNG UND FILMBILDUNGSVERFAHREN

APPAREIL DE FORMATION DE FILM ET PROCÉDÉ DE FORMATION DE FILM

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.12.2015 JP 2015251021**

(43) Date of publication of application:
**31.10.2018 Bulletin 2018/44**

(73) Proprietor: **Konica Minolta, Inc.**
**Tokyo 100-7015 (JP)**

(72) Inventors:
• **JIDAI, Hidetaka**
**Tokyo 100-7015 (JP)**
• **MATSUDA, Ryoji**
**Tokyo 100-7015 (JP)**

(74) Representative: **Henkel & Partner mbB**
**Patentanwaltskanzlei, Rechtsanwaltskanzlei**
**Maximiliansplatz 21**
**80333 München (DE)**

(56) References cited:
**EP-A- 2 246 170        EP-A1- 2 626 441
EP-A2- 0 516 436       JP-A- 2006 124 778
JP-A- 2006 176 862    JP-A- 2014 145 091
JP-A- S61 250 163       US-A1- 2005 023 135
US-A1- 2013 092 528**

# EP 3 396 016 B1

## Description

Technological Field

The present invention relates to a film formation apparatus and a film formation method, and, in particular, relates to a technology for reducing deviation from a desired thickness.

Background Art

Technologies for forming thin films, such as sputtering and vapor deposition, are widely known. Making film thickness(es) of a thin film uniform is important to realize functions of the thin film(s). In particular, in a multilayer film composed of many layers made of metal, dielectrics and/or the like being stacked, change in layer thickness between the layers greatly affects the entire film thickness of the multilayer film. Examples of the multilayer film include optical films, such as an antireflection film.

A technology for reducing difference in film thickness of a thin film is disclosed in JP 2003-321770 A.

In JP 2003-321770 A, a substrate 10 is rotated such that a vapor deposition point on the substrate 10 at the start of vapor deposition is matched with a vapor deposition point on the substrate 10 at the end of vapor deposition (first embodiment), a rotational speed of the substrate 10 is set according to a target film thickness non-uniformity value a (second embodiment), or the rotational speed of the substrate 10 is set according to the target film thickness non-uniformity value a, a forming speed $\alpha$ and a desired film thickness d (third embodiment).

US 2013/0092528 A1 discloses a film-forming device including a chamber in which a substrate is disposed, a target, disposed within the chamber, which contains a material from which a film is formed, a substrate-supporting table disposed inside the chamber, a driving unit that rotates the substrate-supporting table, a sputtering cathode that causes sputtered particles to be incident on the substrate from an oblique direction, and a control unit that controls the driving unit by setting a rotation period so that a sputtering film formation time required to form a film having a desired thickness is an integer multiple of a rotation period of the substrate-supporting table.

EP 2246170 A1 discloses a seamless mold manufacturing method having the steps of forming a thermal reaction type resist layer on a sleeve-shaped mold, and exposing using a laser and developing the thermal reaction type resist layer and thereby forming a fine mold pattern while the sleeve rotates. To ensure resist layer thickness accuracy the rotation speed of the sleeve is approximately determined by the total number of rotations that is the product of the speed and the deposition time. When the total number of deposition rotations is low, due to the effect of fluctuations in the deposition rate by shutter open/close time for starting and finishing deposition, mechanical axial fluctuations of the sleeve rotation axis, temperature variations during deposition and the like, the resist thickness uniformity degrades in the circumference. To solve this problem, by increasing the total number of rotations in the deposition, the deposition rate variations are averaged, and it is possible to reduce fluctuations.

Summary of the Invention

Problems to be Solved by the Invention

However, in forming of a multilayer film, if, like the technology of the first embodiment of JP 2003-321770 A, a forming point at the start of film formation is simply matched with a forming point at the end of film formation, forming time is extended, and deviation from a desired film thickness occurs accordingly. If, like the technologies of the second and third embodiments of JP 2003-321770A, the rotational speed of a substrate is set according to, for example, the target film thickness non-uniformity value a, although difference in layer thickness in a layer is suppressed, a micro error in layer thickness between layers occurs, and accordingly, in a multilayer film composed of such layers being stacked, deviation from a desired film thickness occurs.

Hence, one of objects of the present invention is to provide a film formation apparatus and a film formation method that can reduce deviation from a desired thickness.

Means for Solving the Problems

In order to achieve at least one of the abovementioned objects, a film formation apparatus of the present invention comprises the features of claim 1 or claim 3 and includes inter alia:

a film formation apparatus that forms a multilayer film including (n + 1) or more layers, wherein n represents a positive integer of 1 or larger, the film formation apparatus including:

    a rotational body that rotates while supporting a to-be-film-formed material;

a film formation mechanism that performs a film formation process on the to-be-film-formed material; and
a control mechanism that controls rotation of the rotational body, wherein the control mechanism calculates a number of rotations of the rotational body from a desired layer thickness of a layer of the multilayer film, a default forming rate of the film formation mechanism and a default rotational speed of the rotational body, and adjusts the rotational speed of the rotational body in such a way as to make the calculated number of rotations of the rotational body closer to an integer.

Further, in order to achieve at least one of the abovementioned objects, a film formation method of the present invention comprises the features of claim 8 or 10 and includes inter alia:

a film formation method for forming a multilayer film including (n + 1) or more layers, wherein n represents a positive integer of 1 or larger, by using a film formation apparatus including a rotational body that rotates while supporting a to-be-film-formed material and a film formation mechanism that performs a film formation process on the to-be-film-formed material, the film formation method including:
calculating a number of rotations of the rotational body from a desired layer thickness of a layer of the multilayer film, a default forming rate of the film formation mechanism and a default rotational speed of the rotational body, and adjusting the rotational speed of the rotational body in such a way as to make the calculated number of rotations of the rotational body closer to an integer.

Advantageous Effects of the Invention

The present invention can reduce deviation from a desired thickness.

Brief Description of the Drawings

FIG. 1 is a conceptual diagram showing configuration of a film formation apparatus (sputtering apparatus).
FIG. 2A is a diagram to explain a positional relationship of substrates at the start of film formation.
FIG. 2B is a diagram to explain a positional relationship of the substrates at the end of film formation.
FIG. 3 is a diagram to explain a relationship of formation of the $m^{th}$ section and formation of the $(m + 1)^{th}$ section of the $n^{th}$ layer.
FIG. 4 shows a modification of the film formation apparatus shown in FIG. 1.
FIG. 5 is a conceptual diagram showing a temporal relationship of a film formation process (sputtering) and an oxygen plasma process.
FIG. 6 is a conceptual diagram showing configuration of a film formation apparatus (vapor deposition apparatus).

Embodiments for Carrying out the Invention

Hereinafter, a preferred embodiment(s) of the present invention is described with reference to the drawings.

[Film Formation Apparatus]

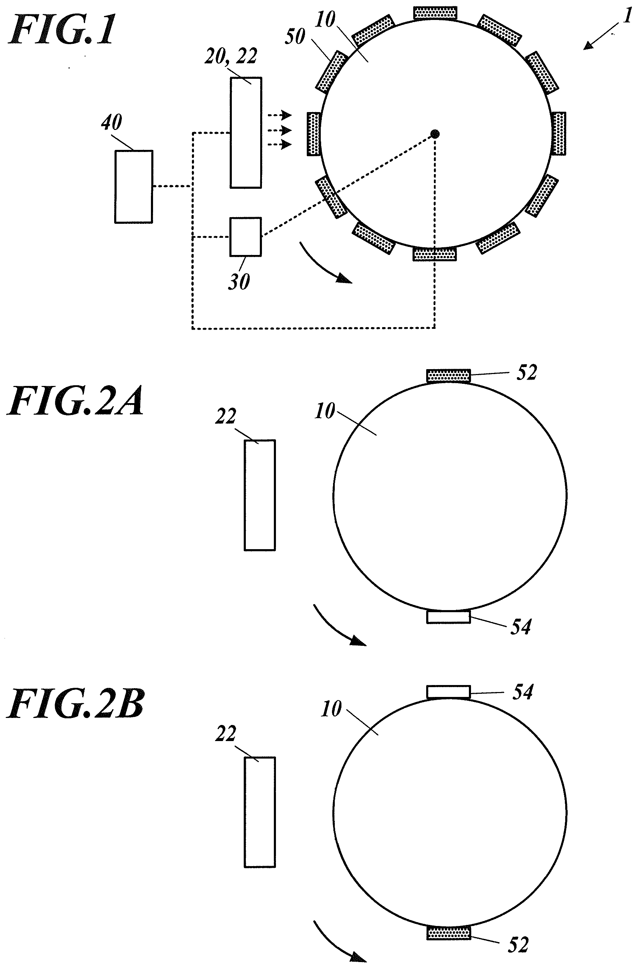

As shown in FIG. 1, a film formation apparatus 1 is a film formation apparatus (sputtering apparatus) that forms multilayer films and includes a drum 10, a film formation mechanism 20, a monitor mechanism 30 and a control mechanism 40 as main components.

The drum 10 supports a plurality of substrates 50. The drum 10 is an example of a rotational body that rotates while supporting the substrates 50. The substrates 50 are an example of to-be-film-formed material, on which a film is formed. Here, glass substrates are used as the substrates 50.

The film formation mechanism 20 is a mechanism that performs a film formation process on the substrates 50, and, what is called, a sputtering mechanism. The film formation mechanism 20 has a target 22. The film formation mechanism 20 takes the drum 10 (substrates 50) side as the anode and the target 22 side as the cathode, and applies a high voltage to the cathode side. As a result of that, gas ion atoms hit the surface of the target 22, and the target material substances ejected thereby are accumulated on the substrates 50.

The monitor mechanism 30 that monitors the rotational speed of the drum 10 is connected to the drum 10. As the monitor mechanism 30, a rotary encoder, a laser speed measuring device or the like is used. If the drum 10 is rotationally driven by a motor, the monitor mechanism 30 may be attached to the rotational shaft, or may be attached to the drum 10 itself. The control mechanism 40 is connected to and controls the drum 10, the film formation mechanism 20 and the monitor mechanism 30.

According to this film formation apparatus 1, the control mechanism 40 controls rotation of the drum 10 and operation of the film formation mechanism 20 on the basis of the monitoring result by the monitor mechanism 30 such that a multilayer film of (n + 1) or more layers being stacked on the substrates 50 is formed on the substrate(s) 50, wherein n represents a positive integer of 1 or larger.

[Film Formation Method]

Next, a film formation method using the film formation apparatus 1 is described.

The film formation method described below is stored in advance in the control mechanism 40 as a film formation program, and the control mechanism 40 performs a process by reading the film formation program.

The control mechanism 40 calculates forming time from a desired thickness of each layer of the multilayer film and a default forming rate of the film formation mechanism 20, and calculates the number of rotations of the drum 10 from the calculated forming time and a default rotational speed of the drum 10.

<Case 1>

For example, if the desired thickness is 60 nm, and the forming rate is 0.5 nm/sec, the forming time is 60/0.5 = 120 sec = 2 min. Then, if the rotational speed of the drum 10 is 65 rpm, (round per minute), the number of rotations of the drum 10 at the time of film formation is 2 min $\times$ 65 rpm = 130.

In this case, because the number of rotations of the drum 10 is an integer, the numbers of times that the respective substrates 50 pass through the target 22 are the same, and accordingly the layer having the desired thickness is formed on each of the substrates 50.

<Case 2>

Meanwhile, if the desired thickness is 69 nm, the forming time is 69/0.5 = 138 sec = 2.3 min. Then, the number of rotations of the drum 10 at the time of film formation is 2.3 min $\times$ 65 rpm = 149.5.

In this case, if, at the start of film formation, a substrate 52 and a substrate 54 are set as shown in FIG. 2A, at the end of film formation, a positional relationship of the substrate 52 and the substrate 54 is reversed as shown in FIG. 2B. That is, the substrate 52 passes through the target 22 150 times, whereas the substrate 54 passes through the target 22 149 times. Consequently, the substrate 54 has a layer thickness that is about 0.6% thinner than the substrate 52 has, and accordingly the thickness of the layer is not uniform.

If, like the first embodiment of Patent Document 1, positions of the substrates 52 and 54 at the start of film formation are simply matched with those of the substrates 52 and 54 at the end of film formation, the substrates 52 and 54 need to be further caracoled (the forming time needs to be extended). This causes deviation of the film thickness of the layer from the desired thickness.

In this embodiment, the control mechanism 40 adjusts the rotational speed of the drum 10 in such a way as to make the calculated number of rotations of the drum 10 closer to an integer.

In the case 2, the rotational speed of the drum 10 is adjusted from 65 rpm to 65.217 rpm.

In this case, the number of rotations of the drum 10 is 2.3 min $\times$ 65.217 rpm = 149.999, namely, almost 150.

By the way, the drum 10 basically keeps rotating at a set rotational speed.

However, a micro error may occur, and the rotational speed of the drum 10 may change accordingly.

For example, in the case 1, if the set rotational speed of the drum 10 is 65 rpm, but the actual rotational speed of the drum 10 is 65.1 rpm, the number of rotations of the drum 10 is 2 min $\times$ 65.1 = 130.2. In this case, among the substrates 50 supported by the drum 10, 20% of the substrates 50 make 131 rotations, and the other 80% of the substrates 50 make 130 rotations. Accordingly, 20% of the substrates 50 have the layer having a thickness that is about 0.8% thicker than the others have. It is considered that such a phenomenon could occur in the middle of film formation too.

Hence, in this embodiment, it is preferable that the control mechanism 40 adjust the rotational speed of the drum 10 with any of speed adjustment examples 1 to 3 below.

[Speed Adjustment Example 1]

The control mechanism 40 grasps the rotational speed of the drum 10 for the $n^{th}$ layer from the monitoring result by the monitor mechanism 30, and adjusts the rotational speed of the drum 10 for the $(n + 1)^{th}$ layer and/or the following layer(s). The "$(n + 1)^{th}$ layer and/or the following layer(s)" may indicate the $(n + 1)^{th}$ layer only, or may indicate any or all of the subsequent layers that include the $(n + 1)^{th}$ layer, namely, means at least one layer among the subsequent layers that include the $(n + 1)^{th}$ layer.

For example, let's assume that, in the case 2 where the desired thickness is 69 nm, the forming rate is 0.5 nm/sec, and accordingly the calculated rotational speed of the drum 10 is 65.217 rpm, the rotational speed of the drum 10 for the $n^{th}$ layer has changed to 65.4 rpm. If film formation continues at this rotational speed, the number of rotations for the $n^{th}$ layer is calculated by (number of rotations per second) $\times$ (forming time), namely, is $(65.4/60) \times (69/0.5) = 150.42$. In order to make the number of rotations for the $n^{th}$ layer closer to the closest integer, namely, 150, the rotational speed of the drum 10 for the $n^{th}$ layer is calculated as $(150 \times 60)/(69/0.5) = 65.217$ rpm. Hence, the control mechanism 40 controls rotation of the drum 10 and thereby adjusts the rotational speed of the drum 10 for the $(n + 1)^{th}$ layer and/or the following layer(s) from 65.4 rpm to the original 65.217 rpm.

In the speed adjustment example 1, the control mechanism 40 needs to set a measurement interval t [sec] of the monitor mechanism 30 and the number of rotations A of the drum 10 required for one measurement in such a way as to satisfy a conditional formula (1).

$$(Ra^2 \times t \times da) /$$
$$(60 \times (60 \times s \times A + Ra \times t \times s)) \leq 0.05 \qquad \ldots (1)$$

In the conditional formula (1), Ra represents the rotational speed [rpm] of the drum 10 for the $(n + 1)^{th}$ layer, da represents the desired thickness [nm] of the $(n + 1)^{th}$ layer, and s represents the forming rate [nm/sec] of the film formation mechanism 20.

The left-hand side of the conditional formula (1) expresses the maximum "error in the number of rotations" that could occur by difference between the number of rotations when film formation is performed at the rotational speed of the drum 10 measured by the monitor mechanism 30 and the number of rotations when film formation is performed at the actual rotational speed of the drum 10.

The conditional formula (1) indicates that the error in the number of rotations is within a range of plus or minus 0.05 rotations.

According to the conditional formula (1), the error in the number of rotations of the drum 10 between formation of the $n^{th}$ layer and formation of the $(n + 1)^{th}$ layer can be held within the range of plus or minus 0.05 rotations, and when formation of the $n^{th}$ layer and formation of the $(n + 1)^{th}$ layer are compared with one another, 90% of their areas can be formed under the same condition.

The error in the number of rotations expressed by the left-hand side of the conditional formula (1) is derived as follows.

Time T [sec] required for one measurement is expressed by $T = (A / Ra) \times 60$.

The maximum error in time caused by one measurement is t [sec]. This is because the measurement interval of the monitor mechanism 30 is t [sec].

The actual rotational speed Ra [rpm] of the drum 10 is expressed by $Ra = (Ra \times T + Ra \times t) / (T + t)$.

The rotational speed Rb [rpm] of the drum 10 including the error in time t is expressed by $Rb = (A / (T + t)) \times 60$.

Accordingly, an error in the rotational speed $(Ra - Rb)$ [rpm] of the drum 10 is expressed by $Ra - Rb = (Ra \times T + Ra \times t) / (T + t)) - ((A / (T + t)) \times 60)$.

By substituting $T = (A / Ra) \times 60$ into the above, the above is expressed by $Ra - Rb = (Ra^2 \times t) / (A \times 60 + Ra \times t)$.

By converting the error in the rotational speed in terms of the number of rotations, the error in the number of rotations is expressed by $(da / s) \times (Ra - Rb) / 60 = (da \times Ra^2 \times t) / ((s \times A \times 60 + s \times Ra \times t) \times 60)$, and the conditional formula (1) is derived.

[Speed Adjustment Example 2]

The control mechanism 40 grasps the rotational speed of the drum 10 for the $m^{th}$ section (m represents a positive integer of 1 or larger) of the $n^{th}$ layer from the monitoring result by the monitor mechanism 30, and adjusts the rotational speed of the drum 10 for the $(m + 1)^{th}$ section and/or the following section(s) of the $n^{th}$ layer.

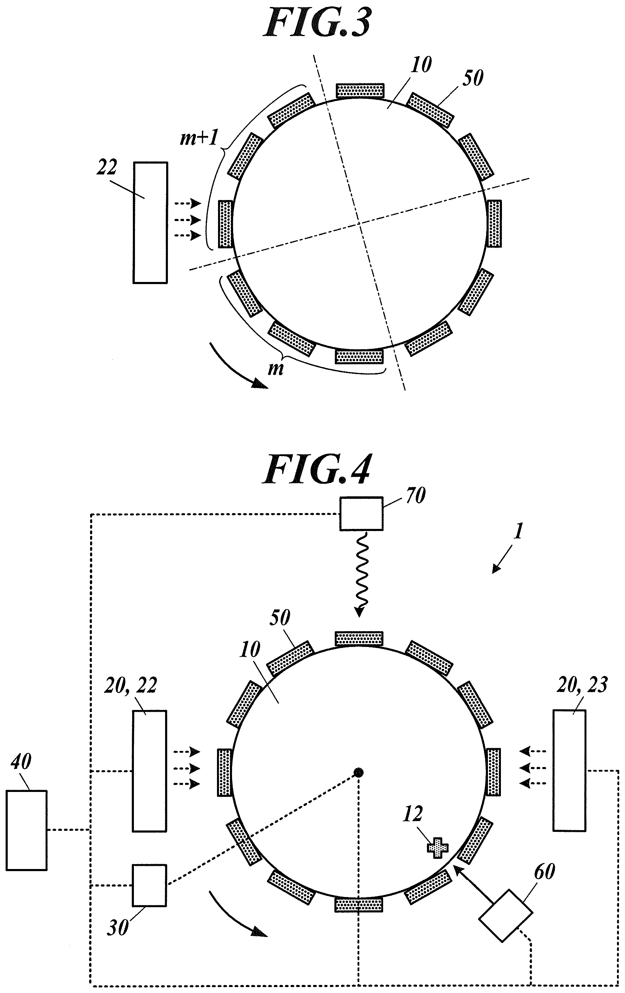

That is, suppose, as shown in FIG. 3, that the large number of the substrates 50 is sectioned. When the $n^{th}$ layer is formed, the control mechanism 40 grasps the rotational speed of the drum 10 for the $m^{th}$ section from the monitoring result by the monitor mechanism 30, and adjusts the rotational speed of the drum 10 for the $(m + 1)^{th}$ section and/or the following section(s). The "$(m + 1)^{th}$ section and/or the following section(s)" may indicate the $(m + 1)^{th}$ section only, or may indicate any or all of the subsequent sections that include the $(m + 1)^{th}$ section, namely, means at least one section among the subsequent sections that include the $(m + 1)^{th}$ section.

FIG. 3 shows an example which is on the assumption that the large number of the substrates 50 is divided into four sections.

In the speed adjustment example 2, the control mechanism 40 needs to set the measurement interval t [sec] of the monitor mechanism 30 and the number of rotations A of the drum 10 required for one measurement in such a way as to satisfy a conditional formula (2).

$$(Rc^2 \times t \times dc) /$$

$$(60 \times (60 \times s \times A + Rc \times t \times s)) \leq 0.05 \qquad \ldots(2)$$

In the conditional formula (2), Rc represents the rotational speed [rpm] of the drum 10 for the $(m + 1)^{th}$ section and/or the following section(s) of the $n^{th}$ layer, dc represents the desired layer thickness [nm] of the $n^{th}$ layer of the multilayer film, and s represents the forming rate [nm/sec] of the film formation mechanism 20.

The conditional formula (2) is derived by the same principles as the conditional formula (1).

According to the conditional formula (2), in formation of the $n^{th}$ layer, the error in the number of rotations of the drum 10 between formation of the $m^{th}$ section and formation of the $(m + 1)^{th}$ section can be held within the range of plus or minus 0.05 rotations, and when formation of the $m^{th}$ section and formation of the $(m + 1)^{th}$ section are compared with one another, 90% of their areas can be formed under the same condition.

[Speed Adjustment Example 3]

The control mechanism 40 always grasps the rotational speed of the drum 10 from the monitoring result by the monitor mechanism 30, and adjusts the rotational speed of the drum 10 in real time.

In the case 2, the control mechanism 40 keeps the rotational speed of the drum 10 at 65.217 rpm.

According to the embodiment described above, while the desired thickness of each layer of the multilayer film, the default forming rate of the film formation mechanism 20 and the forming time thereof are fixed, the rotational speed of the drum 10 is adjusted and controlled such that the number of rotations of the drum 10 becomes closer to an integer.

Hence, unlike the technology of the first embodiment of Patent Document 1, there is no change in the forming condition (the forming rate and the forming time). For example, the forming time is not extended. This prevents deviation from the desired thickness from occurring. Further, when its layers are compared with one another, there is no change in the forming condition. This prevents an error in layer thickness between the layers from being occurring.

Thus, according to the embodiment, deviation from the desired thickness can be reduced.

In the case (the speed adjustment examples 1 to 3 included) described above where the control mechanism 40 adjusts the rotational speed of the drum 10 in such a way as to make the calculated number of rotations of the drum 10 closer to an integer, the control mechanism 40 may also adjust the forming time or the forming rate of the film formation mechanism 20 in such a way as to make the calculated number of rotations of the drum 10 further closer to an integer.

In the case 2, if the forming time is adjusted from 2.3 min to 2.30002 min, the number of rotations of the drum is 2.30002 × 65.217 rpm = 150.0005, namely, further closer to 150. If the forming time is 2.30002 min, the forming rate is 69 nm / 2.30002 min = 0.4999 nm/sec.

Hence, in the case 2, the forming time may be adjusted from 2.3 min to 2.30002 min, or the forming rate may be adjusted from 0.5 nm/sec to 0.4999 nm/sec.

For clear explanations of the film formation method, in the above, an example is described in which the control mechanism 40 controls operation of one film formation mechanism 20 for forming the multilayer film.

As shown in FIG. 4, two film formation mechanisms 20 may be installed, and the control mechanism 40 may alternately control operations of the two film formation mechanisms 20 for forming the multilayer film. In this case, the target 22 is set in one film formation mechanism 20, and a target 23 different from the target 22 is set in the other film formation mechanism 20. The number of film formation mechanisms 20 to be installed can be appropriately changed, and may be changed according to the number of types of layers of the multilayer film.

As shown in FIG. 4, a detection mechanism 60 that detects a reference point 12 of the drum 10 may be installed in the film formation apparatus 1. The detection mechanism 60 is connected to the control mechanism 40, and accordingly the control mechanism 40 can receive the detection result by the detection mechanism 60. As the detection mechanism 60, an optical sensor or the like is used.

In this configuration, in the case (the speed adjustment examples 1 to 3 included) described above where the control mechanism 40 adjusts the rotational speed of the drum 10 in such a way as to make the calculated number of rotations of the drum 10 closer to an integer, it is preferable that, instead of or in addition to adjusting the forming time or the forming rate of the film formation mechanism(s) 20, the control mechanism 40 adjust a rotational position of the drum 10 on the basis of the detection result by the detection mechanism 60 such that formation of each layer starts at the reference point 12 of the drum 10, finishes at the reference point 12 of the drum 10, or starts and finishes at the reference point 12 of the drum 10.

As shown in FIG. 4, an oxygen plasm mechanism 70 for forming an oxidized film as the multilayer film may be installed in the film formation apparatus 1. The oxygen plasma mechanism 70 is connected to and controlled by the control mechanism 40. The oxygen plasma mechanism 70 is an example of a second film formation mechanism.

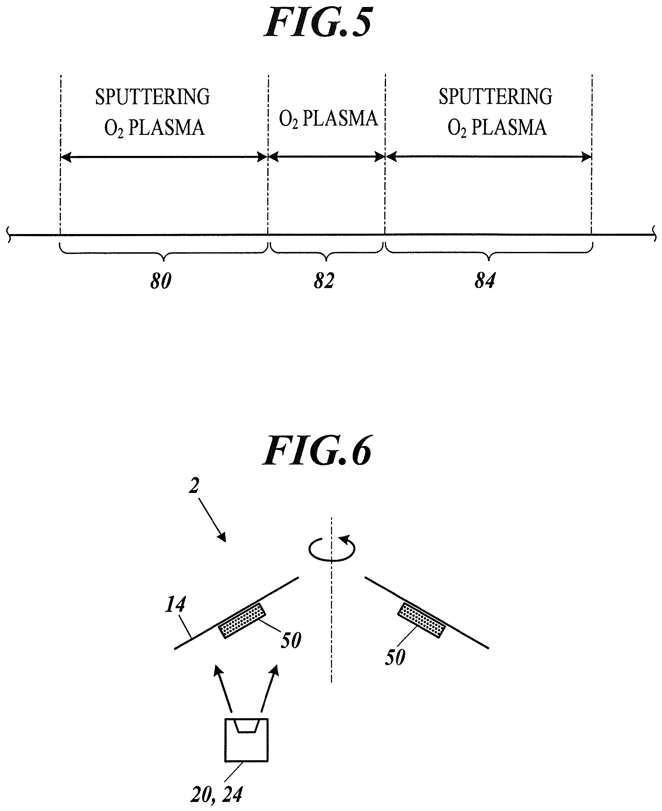

According to this configuration, as shown in FIG. 5, when a shift from a time slot 80 in which one oxidized film is formed to a time slot 84 in which the next/another oxidized film is formed takes place, a time slot 82 in which only an oxygen plasma process by the oxygen plasma mechanism 70 is performed is present therebetween.

It is preferable that the control mechanism 40 adjust the rotational speed of the drum 10 in such a way as to make the calculated number of rotations of the drum 10 closer to an integer in the time slot 82 too.

In the above, the present invention is applied to the film formation apparatus 1 (sputtering apparatus) as an example, but the present invention is also applicable to a film formation apparatus 2 (vapor deposition apparatus) as shown in FIG. 6.

The film formation apparatus 2 is also a film formation apparatus that forms multilayer films, and has a dome 14 and a film formation mechanism 20. The dome 14 supports a plurality of substrates 50. The dome 14 is another example of the rotational body that rotates while supporting the substrates 50. The film formation mechanism 20 has an evaporation source 24. If the dome 14 is rotationally driven by a motor, the monitor mechanism 30 may be attached to the rotational shaft, or may be attached to the dome 14 itself. The present invention is applied to the film formation apparatus 2 by replacing the drum 10 of the film formation apparatus 1 with the dome 14, and replacing the target 22 of the film formation apparatus 1 with the evaporation source 24.

The present invention is, however, preferably applied to the film formation apparatus 1 (sputtering apparatus). The reasons are as follows: in vapor deposition apparatuses, the forming condition changes more or less between the time slot immediately after the start of vapor deposition and the subsequent time slot(s), whereas in sputtering apparatuses, the forming condition hardly changes; in vapor deposition apparatuses, as film formation proceeds, material of the evaporation source 24 decreases, and accordingly replacement of the evaporation source 24 is required, whereas in sputtering apparatuses, replacement of the target 22 is basically not required; and in vapor deposition apparatuses, distance from the evaporation source 24 to the substrates 50 is relatively long, whereas in sputtering apparatuses, distance from the target 22 to the substrates 50 is short, which makes it easy to achieve film formation as designed.

Industrial Applicability

The present invention is preferably applicable, in particular, to providing a film formation apparatus and a film formation method that can reduce deviation from a desired thickness.

Description of Reference Numerals

| 1 | Film Formation Apparatus (Sputtering Apparatus) |
| 2 | Film Formation Apparatus (Vapor Deposition Apparatus) |
| 10 | Drum |
| 12 | Reference Point |
| 14 | Dome |
| 20 | Film Formation Mechanism |
| 22, 23 | Target |
| 24 | Evaporation Source |
| 30 | Monitor Mechanism |
| 40 | Control Mechanism |
| 50 | Substrate |
| 52, 54 | Substrate |
| 60 | Detection Mechanism |
| 70 | Oxygen Plasma Mechanism |

80, 82, 84     Time Slot

52, 54         Substrate

60             Detection Mechanism

70             Oxygen Plasma Mechanism

80, 82, 84     Time Slot

**Claims**

1. A film formation apparatus (1;2) for forming a multilayer film including {n + 1} or more layers, wherein n represents a positive integer of 1 or larger, the film formation apparatus (1;2) comprising:

   a rotational body (10;14) that is configured to rotate while supporting a to-be-film-formed material (50,52,54);
   a film formation mechanism (20) that is configured to perform a film formation process on the to-be-film-formed material (50,52,54);
   a monitor mechanism (30) that is configured to monitor the rotational speed of the rotational body (10) and
   a control mechanism (40) that is configured to control rotation of the rotational body (10;14), wherein the control mechanism (40) is configured to calculate a number of rotations of the rotational body (10;14) from a desired layer thickness of a layer of the multilayer film, a default forming rate of the film formation mechanism (20) and a default rotational speed of the rotational body (10;14), and to adjust the rotational speed of the rotational body (10;14) in such a way as to make the calculated number of rotations of the rotational body (10;14) closer to an integer, and wherein in a first alternative
   the control mechanism (40) is configured to in the step of adjusting the rotational speed of the rotational body (10), grasp the rotational speed of the rotational body (10) for an $n^{th}$ layer from a result of the monitoring by the monitor mechanism (30), and to adjust the rotational speed of the rotational body (10) for an ${n + 1}^{th}$ layer and/or a following layer, wherein n represents a positive integer of 1 or larger; and
   wherein the control mechanism (40) is configured to set a measurement interval t [sec] of the monitor mechanism (30) and a number of rotations A of the rotational body (10) required for one measurement in such a way as to satisfy a conditional formula:

   $$\{Ra^2 \times t \times da\} / \{60 \times \{60 \times s \times A + Ra \times t \times s\}\} \leq 0.05,$$

   wherein Ra represents the rotational speed [rpm] of the rotational body (10) for the ${n + 1}^{th}$ layer, da represents the desired layer thickness [nm] of the ${n + 1}^{th}$ layer, and s represents the forming rate [nm/sec] of the film formation mechanism (20);
   and in a second alternative
   the to-be-film-formed material includes a number of substrates (50,52,54); wherein the number of substrates is divided into plural sections;
   the control mechanism (40) is configured to, in the step of adjusting the rotational speed of the rotational body (10), grasp the rotational speed of the rotational body (1 O) for an m"'1 section of an nu'l layer from a result of the monitoring by the monitor mechanism (80), and
   to adjust the rotational speed of the rotational body (10) for an {m + IF" section and/or a following section at the n"'1 layer, wherein m represents a positive integer of 1 or larger, and
   wherein the control mechanism (40) is further configured to set a measurement interval t [sec] of the monitor mechanism (30) and a number of rotations A of the rotational body (1 0) required for one measurement in such a way as to satisfy a conditional formula:

   $$\{Rc^2 \times t \times dc\} / \{60 \times \{60 \times s \times A + Rc \times t \times s\}\} \leq 0.05$$

   wherein Rc represents the rotational speed [rpm] of the rotational body (10) for the ${m + I}^{th}$ section and/or a following section of the $n^{th}$ layer, dc represents the desired layer thickness [nm] of the $n^{th}$ layer; and s represents the forming rate [nm/sec] of the film formation mechanism (20).

2. The film formation apparatus (1) according to claim 1, wherein the control mechanism (40) is configured to adjust a forming time or the forming rate of the film formation mechanism (20) in such a way as to make the calculated number of rotations of the rotational body (10) closer to the integer.

3. The film formation apparatus (1) according to any one of claims 1 or 2, comprising a detection mechanism (60) that is configured to detect a reference point (12) of the rotational body (10), wherein
the control mechanism (40) is configured to adjust a rotational position of the rotational body (10) based on a result of the detection by the detection mechanism (60) such that formation of each layer starts at the reference point (12) of the rotational body (10), finishes at the reference point (12) of the rotational body (10), or starts and finishes at the reference point (12) of the rotational body (10).

4. The film formation apparatus (1) according to any one of claims 1 to 3, comprising a second film formation mechanism (70) that is configured to perform the film formation process on the to-be-film-formed material (50), wherein
the control mechanism (40) is configured to adjust the rotational speed of the rotational body (10) in such a way as to make the calculated number of rotations of the rotational body (10) closer to the integer even in a time slot (82) for shifting from formation of the multilayer film to formation of a next multilayer film.

5. A film formation method for forming a multilayer film including $\{n + 1\}$ or more layers, wherein n represents a positive integer of 1 or larger, using a film formation apparatus (1;2) including a rotational body (10;14) that rotates while supporting a to-be-film-formed material (50,52,54), and a film formation mechanism (20) that performs a film formation process on the to-be-film-formed material (50,52,54), a monitor mechanism (30) that monitors the rotational speed of the rotational body (10); the film formation method comprising:

controlling rotation of the rotational body (10;14),
calculating a number of rotations of the rotational body (10;14) from a desired layer thickness of a layer of the multilayer film, a default forming rate of the film formation mechanism (20) and a default rotational speed of the rotational body (10;14), and adjusting the rotational speed of the rotational body (10;14) in such a way as to make the calculated number of rotations of the rotational body (10;14) closer to an integer,
wherein in a first alternative
the film formation method comprises, in the step of adjusting the rotational speed of the rotational body (10), grasping the rotational speed of the rotational body (10) for an $n^{th}$ layer from a result of the monitoring by the monitor mechanism (30) and adjusting the rotational speed of the rotational body (10) for an $\{n + 1\}^{th}$ layer and/or a following layer, wherein n represents a positive integer of 1 or larger; and
wherein the film formation method comprises setting a measurement interval t [sec] of the monitor mechanism (30) and a number of rotations A of the rotational body (10) required for one measurement in such a way as to satisfy a conditional formula:

$$\{Ra^2 \times t \times da\} / \{60 \times \{60 \times s \times A + Ra \times t \times s\}\} \leq 0.05,$$

wherein Ra represents the rotational speed [rpm] of the rotational body (10) for the $\{n + 1\}^{th}$ layer, da represents the desired layer thickness [nm] of the $\{n + 1\}^{th}$ layer, and s represents the forming rate [nm/sec] of the film formation mechanism (20);
in a second alternative
the to-be-film-formed material (50,52,54) includes a number of substrates, which number is divided into plural sections,
wherein the film formation method comprises, in the step of adjusting the rotational speed of the rotational body (10), grasping the rotational speed of the rotational body (10) for an $m^{th}$ section of an $n^{th}$ layer from a result of the monitoring by the monitor mechanism (30) and adjusting the rotational speed of the rotational body (10) for an $\{m + 1\}^{th}$ section and/or a following section of the $n^{th}$ layer, wherein m represents a positive integer of 1 or larger, and
the film formation method comprises setting a measurement interval t [sec] of the monitor mechanism (30) and a number of rotations A of the rotational body (10) required for one measurement in such a way as to satisfy a conditional formula:

$$\{Rc^2 \times t \times dc\} / \{60 \times \{60 \times s \times A + Rc \times t \times s\}\} \leq 0.05,$$

wherein Rc represents the rotational speed [rpm] of the rotational body (10) for the $\{m + 1\}^{th}$ section and/or the following section of the $n^{th}$ layer, dc represents the desired layer thickness [nm] of the $n^{th}$ layer of the multilayer film, and s represents the forming rate [nm/sec] of the film formation mechanism (20).

6.  The film formation method according toclaim 5, comprising adjusting a forming time or the forming rate of the film formation mechanism (20) in such a way as to make the calculated number of rotations of the rotational body (10) closer to the integer.

7.  The film formation method according to any one of claims 5 or 6, wherein

    the film formation apparatus (1) includes a detection mechanism (60) that detects a reference point (12) of the rotational body (10), and
    the film formation method comprises adjusting a rotational position of the rotational body (10) based on a result of the detection by the detection mechanism (60) such that formation of each layer starts at the reference point (12) of the rotational body (10), finishes at the reference point (12) of the rotational body (10), or starts and finishes at the reference point (12) of the rotational body (10).

8.  The film formation method according to any one of claims 5 to 7, wherein

    the film formation apparatus (1) includes a second film formation mechanism (70) that performs the film formation process on the to-be-film-formed material (50), and
    the film formation method comprises adjusting the rotational speed of the rotational body (10) in such a way as to make the calculated number of rotations of the rotational body (10) closer to the integer even in a time slot (82) for shifting from formation of the multilayer film to formation of a next multilayer film.

**Patentansprüche**

1.  Filmbildungsvorrichtung (1; 2) zum Bilden eines Mehrschichtfilms, der (n + 1) oder mehr Schichten umfasst, wobei n eine positive ganze Zahl von 1 oder größer darstellt, wobei die Filmbildungsvorrichtung (1; 2) umfasst:

    einen Drehkörper (10; 14), der konfiguriert ist, um sich zu drehen, während er ein zu befilmendes Material (50, 52, 54) trägt;
    einen Filmbildungsmechanismus (20), der konfiguriert ist, um einen Filmbildungsprozess auf dem zu befilmenden Material (50, 52, 54) durchzuführen;
    einen Überwachungsmechanismus (30), der konfiguriert ist, um die Drehgeschwindigkeit des Drehkörpers (10) zu überwachen; und
    einen Steuerungsmechanismus (40), der konfiguriuriert ist, um die Drehung des Drehkörpers (10; 14) zu steuern, wobei der Steuerungsmechanismus (40) konfiguriert ist, um eine Anzahl von Umdrehungen des Drehkörpers (10; 14) aus einer gewünschten Schichtdicke einer Schicht des Mehrschichtfilms, einer Standard-Bildungsrate des Filmbildungsmechanismus (20) und einer Standard-Drehgeschwindigkeit des Drehkörpers (10; 14) zu berechnen, und um die Drehgeschwindigkeit des Drehkörpers (10; 14) derart anzupassen, dass die berechnete Anzahl von Umdrehungen des Drehkörpers (10; 14) näher an eine ganze Zahl gebracht wird, und
    wobei in einer ersten Alternative
    der Steuerungsmechanismus (40) konfiguriert ist, um in dem Schritt des Anpassens der Drehgeschwindigkeit des Drehkörpers (10), die Drehgeschwindigkeit des Drehkörpers (10) für eine n-te Schicht aus einem Ergebnis der Überwachung durch den Überwachungsmechanismus (30) zu erfassen, und die Drehgeschwindigkeit des Drehkörpers (10) für eine (n + 1)-te Schicht und/oder eine nachfolgende Schicht anzupassen, wobei n eine positive ganze Zahl von 1 oder größer darstellt; und
    wobei der Steuerungsmechanismus (40) konfiguriert ist, um ein Messintervall t [sec] des Überwachungsmechanismus (30) und eine Anzahl von Umdrehungen A des Drehkörpers (10), die für eine Messung erforderlich ist, so einzustellen, dass eine bedingte Formel erfüllt wird:

$$\{Ra^2 \times t \times da\} \,/\, \{60 \times \{60 \times s \times A + Ra \times t \times s\}\} \le 0{,}05,$$

    wobei Ra die Drehgeschwindigkeit [rpm] des Drehkörpers (10) für die (n + 1)-te Schicht darstellt, da die gewünschte Schichtdicke [nm] der (n + 1)-ten Schicht darstellt, und s die Bildungsrate [nm/sec] des Filmbildungsmechanismus (20) darstellt;
    und in einer zweiten Alternative
    das zu befilmende Material eine Anzahl von Substraten (50, 52, 54) aufweist; wobei die Anzahl der Substrate in mehrere Abschnitte unterteilt ist;
    der Steuerungsmechanismus (40) konfiguriert ist, um in dem Schritt des Anpassens der Drehgeschwindigkeit des Drehkörpers (10), die Drehgeschwindigkeit des Drehkörpers (10) für einen m-ten Abschnitt einer n-ten Schicht aus einem Ergebnis der Überwachung durch den Überwachungsmechanismus (30) zu erfassen, und die Drehgeschwindigkeit des Drehkörpers (10) für einen (m + 1)-ten Abschnitt und/oder einen nachfolgenden Abschnitt in der n-ten Schicht anzupassen, wobei m eine positive ganze Zahl von 1 oder größer darstellt, und wobei der Steuerungsmechanismus (40) ferner konfiguriert ist, um ein Messintervall t [sec] des Überwachungsmechanismus (30) und eine Anzahl von Umdrehungen A des Drehkörpers (10), die für eine Messung erforderlich ist, so einzustellen, dass eine bedingte Formel erfüllt wird:

$$\{Rc^2 \times t \times dc\} \ / \ \{60 \times \{60 \times s \times A + Rc \times t \times s\}\} \ \leq \ 0{,}05,$$

wobei Rc die Drehgeschwindigkeit [rpm] des Drehkörpers (10) für den (m + 1)-ten Abschnitt und/oder einen nachfolgenden Abschnitt der n-ten Schicht darstellt, dc die gewünschte Schichtdicke [nm] der n-ten Schicht darstellt; und s die Bildungsrate [nm/sec] des Filmbildungsmechanismus (20) darstellt.

2. Filmbildungsvorrichtung (1) nach Anspruch 1, wobei der Steuerungsmechanismus (40) konfiguriert ist, um eine Bildungszeit oder die Bildungsrate des Filmbildungsmechanismus (20) derart anzupassen, dass die berechnete Anzahl von Umdrehungen des Drehkörpers (10) näher an die ganze Zahl gebracht wird.

3. Filmbildungsvorrichtung (1) nach einem der Ansprüche 1 oder 2, umfassend einen Erfassungsmechanismus (60), der konfiguriert ist, um einen Referenzpunkt (12) des Drehkörpers (10) zu erfassen, wobei der Steuerungsmechanismus (40) konfiguriert ist, um eine Drehposition des Drehkörpers (10) basierend auf einem Ergebnis der Erfassung durch den Erfassungsmechanismus (60) so anzupassen, dass die Bildung jeder Schicht am Referenzpunkt (12) des Drehkörpers (10) beginnt, am Referenzpunkt (12) des Drehkörpers (10) endet oder am Referenzpunkt (12) des Drehkörpers (10) beginnt und endet.

4. Filmbildungsvorrichtung (1) nach einem der Ansprüche 1 bis 3, umfassend einen zweiten Filmbildungsmechanismus (70), der konfiguriert ist, um den Filmbildungsprozess auf dem zu befilmenden Material (50) durchzuführen, wobei der Steuerungsmechanismus (40) konfiguriert ist, um die Drehgeschwindigkeit des Drehkörpers (10) derart anzupassen, dass die berechnete Anzahl von Umdrehungen des Drehkörpers (10) sogar in einem Zeitschlitz (82) zum Wechseln von der Bildung des Mehrschichtfilms zur Bildung eines nächsten Mehrschichtfilms näher an die ganze Zahl gebracht wird.

5. Filmbildungsverfahren zum Bilden eines Mehrschichtfilms, der (n + 1) oder mehr Schichten umfasst, wobei n eine positive ganze Zahl von 1 oder größer darstellt, unter Verwendung einer Filmbildungsvorrichtung (1; 2), die einen Drehkörper (10; 14), der sich dreht, während er ein zu befilmendes Material (50, 52, 54) trägt, und einen Filmbildungsmechanismus (20), der einen Filmbildungsprozess auf dem zu befilmenden Material (50, 52, 54) durchführt, einen Überwachungsmechanismus (30), der die Drehgeschwindigkeit des Drehkörpers (10) überwacht, aufweist; wobei das Filmbildungsverfahren umfasst:

Steuern der Drehung des Drehkörpers (10; 14),
Berechnen einer Anzahl von Umdrehungen des Drehkörpers (10; 14) aus einer gewünschten Schichtdicke einer Schicht des Mehrschichtfilms, einer Standard-Bildungsrate des Filmbildungsmechanismus (20) und einer Standard-Drehgeschwindigkeit des Drehkörpers (10; 14), und Anpassen der Drehgeschwindigkeit des Drehkörpers (10; 14) derart, dass die berechnete Anzahl von Umdrehungen des Drehkörpers (10; 14) näher an eine ganze Zahl gebracht wird,

wobei in einer ersten Alternative
das Filmbildungsverfahren im Schritt des Anpassens der Drehgeschwindigkeit des Drehkörpers (10) das Erfassen der Drehgeschwindigkeit des Drehkörpers (10) für eine n-te Schicht aus einem Ergebnis der Überwachung durch den Überwachungsmechanismus (30) und das Anpassen der Drehgeschwindigkeit des Drehkörpers (10) für eine (n + 1)-te Schicht und/oder eine nachfolgende Schicht umfasst, wobei n eine positive ganze Zahl von 1 oder größer darstellt; und wobei das Filmbildungsverfahren das Einstellen eines Messintervalls t [sec] des Überwachungsmechanismus (30) und einer Anzahl von Umdrehungen A des Drehkörpers (10), die für eine Messung erforderlich ist, derart umfasst, dass eine bedingte Formel erfüllt wird:

$$\{Ra^2 \times t \times da\} \ / \ \{60 \times \{60 \times s \times A + Ra \times t \times s\}\} \ \leq \ 0{,}05,$$

wobei Ra die Drehgeschwindigkeit [rpm] des Drehkörpers (10) für die (n + 1)-te Schicht darstellt, da die gewünschte Schichtdicke [nm] der (n + 1)-ten Schicht darstellt, und s die Bildungsrate [nm/sec] des Filmbildungsmechanismus (20) darstellt;

in einer zweiten Alternative

das zu befilmende Material (50, 52, 54) eine Anzahl von Substraten aufweist, wobei die Anzahl in mehrere Abschnitte unterteilt ist,

wobei das Filmbildungsverfahren im Schritt des Anpassens der Drehgeschwindigkeit des Drehkörpers (10) das Erfassen der Drehgeschwindigkeit des Drehkörpers (10) für einen m-ten Abschnitt einer n-ten Schicht aus einem Ergebnis der Überwachung durch den Überwachungsmechanismus (30) und das Anpassen der Drehgeschwindigkeit des Drehkörpers (10) für einen (m + 1)-ten Abschnitt und/oder einen nachfolgenden Abschnitt der n-ten Schicht umfasst, wobei m eine positive ganze Zahl von 1 oder größer darstellt, und das Filmbildungsverfahren das Einstellen eines Messintervalls t [sec] des Überwachungsmechanismus (30) und einer Anzahl von Umdrehungen A des Drehkörpers (10), die für eine Messung erforderlich ist, derart umfasst, dass eine bedingte Formel erfüllt wird:

$$\{Rc^2 \times t \times dc\} \; / \; \{60 \times \{60 \times s \times A + Rc \times t \times s\}\} \leq 0,05,$$

wobei Rc die Drehgeschwindigkeit [rpm] des Drehkörpers (10) für den (m + 1)-ten Abschnitt und/oder den nachfolgenden Abschnitt der n-ten Schicht darstellt, dc die gewünschte Schichtdicke [nm] der n-ten Schicht des Mehrschichtfilms darstellt, und s die Bildungsrate [nm/sec] des Filmbildungsmechanismus (20) darstellt.

6. Filmbildungsverfahren nach Anspruch 5, umfassend das Anpassen einer Bildungszeit oder der Bildungsrate des Filmbildungsmechanismus (20) derart, dass die berechnete Anzahl von Umdrehungen des Drehkörpers (10) näher an die ganze Zahl gebracht wird.

7. Filmbildungsverfahren nach einem der Ansprüche 5 oder 6, wobei

die Filmbildungsvorrichtung (1) einen Erfassungsmechanismus (60) aufweist, der einen Referenzpunkt (12) des Drehkörpers (10) erfasst, und

das Filmbildungsverfahren das Anpassen einer Drehposition des Drehkörpers (10) basierend auf einem Ergebnis der Erfassung durch den Erfassungsmechanismus (60) derart umfasst, dass die Bildung jeder Schicht am Referenzpunkt (12) des Drehkörpers (10) beginnt, am Referenzpunkt (12) des Drehkörpers (10) endet oder am Referenzpunkt (12) des Drehkörpers (10) beginnt und endet.

8. Filmbildungsverfahren nach einem der Ansprüche 5 bis 7, wobei

die Filmbildungsvorrichtung (1) einen zweiten Filmbildungsmechanismus (70) aufweist, der den Filmbildungsprozess auf dem zu befilmenden Material (50) durchführt, und

das Filmbildungsverfahren das Anpassen der Drehgeschwindigkeit des Drehkörpers (10) derart umfasst, dass die berechnete Anzahl von Umdrehungen des Drehkörpers (10) sogar in einem Zeitschlitz (82) zum Wechseln von der Bildung des Mehrschichtfilms zur Bildung eines nächsten Mehrschichtfilms näher an die ganze Zahl gebracht wird.

## Revendications

1. Appareil de formation de film (1 ; 2) pour former un film multicouche incluant (n + 1) couches ou plus, où n représente un entier positif de 1 ou plus, l'appareil de formation de film (1 ; 2) comprenant :

un corps rotatif (10 ; 14) qui est configuré pour tourner tout en supportant un matériau à former en film (50, 52, 54) ;

un mécanisme de formation de film (20) qui est configuré pour effectuer un processus de formation de film sur le matériau à former en film (50, 52, 54) ;

un mécanisme de surveillance (30) qui est configuré pour surveiller la vitesse de rotation du corps rotatif (10) ; et

un mécanisme de commande (40) qui est configuré pour commander la rotation du corps rotatif (10 ; 14), où le mécanisme de commande (40) est configuré pour calculer un nombre de rotations du corps rotatif (10 ; 14) à partir d'une épaisseur de couche souhaitée d'une couche du film multicouche, d'une vitesse de formation par défaut du mécanisme de formation de film (20) et d'une vitesse de rotation par défaut du corps rotatif (10 ; 14), et pour ajuster la vitesse de rotation du corps rotatif (10 ; 14) de manière à rendre le nombre calculé de rotations du corps rotatif (10 ; 14) plus proche d'un entier, et

où dans une première alternative

le mécanisme de commande (40) est configuré pour, dans l'étape d'ajustement de la vitesse de rotation du corps rotatif (10), saisir la vitesse de rotation du corps rotatif (10) pour une n-ième couche à partir d'un résultat de la surveillance par le mécanisme de surveillance (30), et pour ajuster la vitesse de rotation du corps rotatif (10) pour une (n + 1)-ième couche et/ou une couche suivante, où n représente un entier positif de 1 ou plus ; et

où le mécanisme de commande (40) est configuré pour définir un intervalle de mesure t [s] du mécanisme de surveillance (30) et un nombre de rotations A du corps rotatif (10) requis pour une mesure de manière à satisfaire une formule conditionnelle :

$$\{Ra^2 \times t \times da\} \, / \, \{60 \times \{60 \times s \times A + Ra \times t \times s\}\} \le 0{,}05,$$

où Ra représente la vitesse de rotation [tr/min] du corps rotatif (10) pour la (n + 1)-ième couche, da représente l'épaisseur de couche souhaitée [nm] de la (n + 1)-ième couche, et s représente la vitesse de formation [nm/s] du mécanisme de formation de film (20) ;

et dans une deuxième alternative

le matériau à former en film inclut un certain nombre de substrats (50, 52, 54) ; où le nombre de substrats est divisé en plusieurs sections ;

le mécanisme de commande (40) est configuré pour, dans l'étape d'ajustement de la vitesse de rotation du corps rotatif (10), saisir la vitesse de rotation du corps rotatif (10) pour une m-ième section d'une n-ième couche à partir d'un résultat de la surveillance par le mécanisme de surveillance (30), et

pour ajuster la vitesse de rotation du corps rotatif (10) pour une (m + 1)-ième section et/ou une section suivante au niveau de la n-ième couche, où m représente un entier positif de 1 ou plus, et

où le mécanisme de commande (40) est en outre configuré pour définir un intervalle de mesure t [s] du mécanisme de surveillance (30) et un nombre de rotations A du corps rotatif (10) requis pour une mesure de manière à satisfaire une formule conditionnelle :

$$\{Rc^2 \times t \times dc\} \, / \, \{60 \times \{60 \times s \times A + Rc \times t \times s\}\} \le 0{,}05,$$

où Rc représente la vitesse de rotation [tr/min] du corps rotatif (10) pour la (m + 1)-ième section et/ou une section suivante de la n-ième couche, dc représente l'épaisseur de couche souhaitée [nm] de la n-ième couche ; et s représente la vitesse de formation [nm/s] du mécanisme de formation de film (20).

2. Appareil de formation de film (1) selon la revendication 1, dans lequel le mécanisme de commande (40) est configuré pour ajuster un temps de formation ou la vitesse de formation du mécanisme de formation de film (20) de manière à rendre le nombre calculé de rotations du corps rotatif (10) plus proche de l'entier.

3. Appareil de formation de film (1) selon l'une quelconque des revendications 1 ou 2, comprenant un mécanisme de détection (60) qui est configuré pour détecter un point de référence (12) du corps rotatif (10), dans lequel le mécanisme de commande (40) est configuré pour ajuster une position de rotation du corps rotatif (10) sur la base d'un résultat de la détection par le mécanisme de détection (60) de telle sorte que la formation de chaque couche commence au point de référence (12) du corps rotatif (10), se termine au point de référence (12) du corps rotatif (10), ou commence et se termine au point de référence (12) du corps rotatif (10).

4. Appareil de formation de film (1) selon l'une quelconque des revendications 1 à 3, comprenant un second mécanisme de formation de film (70) qui est configuré pour effectuer le processus de formation de film sur le matériau à former en film (50), dans lequel le mécanisme de commande (40) est configuré pour ajuster la vitesse de rotation du corps rotatif (10) de manière à rendre le nombre calculé de rotations du corps rotatif (10) plus proche de l'entier même dans un créneau temporel (82) pour le passage de la formation du film multicouche à la formation d'un film multicouche suivant.

5. Procédé de formation de film pour former un film multicouche incluant (n + 1) couches ou plus, où n représente un entier positif de 1 ou plus, en utilisant un appareil de formation de film (1 ; 2) incluant un corps rotatif (10 ; 14) qui tourne tout en supportant un matériau à former en film (50, 52, 54), et un mécanisme de formation de film (20) qui effectue un processus de formation de film sur le matériau à former en film (50, 52, 54), un mécanisme de surveillance (30) qui surveille la vitesse de rotation du corps rotatif (10) ; le procédé de formation de film comprenant :

la commande de la rotation du corps rotatif (10; 14),

le calcul d'un nombre de rotations du corps rotatif (10; 14) à partir d'une épaisseur de couche souhaitée d'une couche du film multicouche, d'une vitesse de formation par défaut du mécanisme de formation de film (20) et d'une vitesse de rotation par défaut du corps rotatif (10; 14), et l'ajustement de la vitesse de rotation du corps rotatif (10; 14) de manière à rendre le nombre calculé de rotations du corps rotatif (10; 14) plus proche d'un entier, où dans une première alternative

le procédé de formation de film comprend, dans l'étape d'ajustement de la vitesse de rotation du corps rotatif (10), la saisie de la vitesse de rotation du corps rotatif (10) pour une n-ième couche à partir d'un résultat de la surveillance par le mécanisme de surveillance (30) et l'ajustement de la vitesse de rotation du corps rotatif (10) pour une (n + 1)-ième couche et/ou une couche suivante, où n représente un entier positif de 1 ou plus ; et où le procédé de formation de film comprend la définition d'un intervalle de mesure t [s] du mécanisme de surveillance (30) et d'un nombre de rotations A du corps rotatif (10) requis pour une mesure de manière à satisfaire une formule conditionnelle :

$$\{Ra^2 \times t \times da\} / \{60 \times \{60 \times s \times A + Ra \times t \times s\}\} \leq 0,05,$$

où Ra représente la vitesse de rotation [tr/min] du corps rotatif (10) pour la (n + 1)-ième couche, da représente l'épaisseur de couche souhaitée [nm] de la (n + 1)-ième couche, et s représente la vitesse de formation [nm/s] du mécanisme de formation de film (20) ;

dans une deuxième alternative

le matériau à former en film (50, 52, 54) inclut un certain nombre de substrats, lequel nombre est divisé en plusieurs sections,

où le procédé de formation de film comprend, dans l'étape d'ajustement de la vitesse de rotation du corps rotatif (10), la saisie de la vitesse de rotation du corps rotatif (10) pour une m-ième section d'une n-ième couche à partir d'un résultat de la surveillance par le mécanisme de surveillance (30) et l'ajustement de la vitesse de rotation du corps rotatif (10) pour une (m + 1)-ième section et/ou une section suivante de la n-ième couche, où m représente un entier positif de 1 ou plus, et

le procédé de formation de film comprend la définition d'un intervalle de mesure t [s] du mécanisme de surveillance (30) et d'un nombre de rotations A du corps rotatif (10) requis pour une mesure de manière à satisfaire une formule conditionnelle :

$$\{Rc^2 \times t \times dc\} / \{60 \times \{60 \times s \times A + Rc \times t \times s\}\} \leq 0,05,$$

où Rc représente la vitesse de rotation [tr/min] du corps rotatif (10) pour la (m + 1)-ième section et/ou la section suivante de la n-ième couche, dc représente l'épaisseur de couche souhaitée [nm] de la n-ième couche du film multicouche, et s représente la vitesse de formation [nm/s] du mécanisme de formation de film (20).

6. Procédé de formation de film selon la revendication 5, comprenant l'ajustement d'un temps de formation ou de la vitesse de formation du mécanisme de formation de film (20) de manière à rendre le nombre calculé de rotations du corps rotatif (10) plus proche de l'entier.

7. Procédé de formation de film selon l'une quelconque des revendications 5 ou 6, dans lequel

l'appareil de formation de film (1) inclut un mécanisme de détection (60) qui détecte un point de référence (12) du corps rotatif (10), et

le procédé de formation de film comprend l'ajustement d'une position de rotation du corps rotatif (10) sur la base d'un résultat de la détection par le mécanisme de détection (60) de telle sorte que la formation de chaque couche commence au point de référence (12) du corps rotatif (10), se termine au point de référence (12) du corps rotatif (10), ou commence et se termine au point de référence (12) du corps rotatif (10).

8. Procédé de formation de film selon l'une quelconque des revendications 5 à 7, dans lequel

l'appareil de formation de film (1) inclut un second mécanisme de formation de film (70) qui effectue le processus de formation de film sur le matériau à former en film (50), et

le procédé de formation de film comprend l'ajustement de la vitesse de rotation du corps rotatif (10) de manière à rendre le nombre calculé de rotations du corps rotatif (10) plus proche de l'entier même dans un créneau temporel (82) pour le passage de la formation du film multicouche à la formation d'un film multicouche suivant.

FIG.1

FIG.2A

FIG.2B

## FIG.3

## FIG.4

## *FIG.5*

| SPUTTERING O$_2$ PLASMA | O$_2$ PLASMA | SPUTTERING O$_2$ PLASMA |
| --- | --- | --- |

*80*　　　　*82*　　　　*84*

## *FIG.6*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003321770 A
- US 20130092528 A1

- EP 2246170 A1